(19) Europäisches Patentamt
European Patent Office
Office européen des brevets

(11) Veröffentlichungsnummer: **0 055 807**
**B1**

# (12) EUROPÄISCHE PATENTSCHRIFT

(45) Veröffentlichungstag der Patentschrift: **06.03.85**

(51) Int. Cl.⁴: **G 03 F 7/02**

(21) Anmeldenummer: **81108842.6**

(22) Anmeldetag: **24.10.81**

(54) **Zur Herstellung von Druck- und Reliefformen geeignete Mehrschichten-Elemente.**

(30) Priorität: **07.01.81 DE 3100175**

(43) Veröffentlichungstag der Anmeldung: **14.07.82 Patentblatt 82/28**

(45) Bekanntmachung des Hinweises auf die Patenterteilung: **06.03.85 Patentblatt 85/10**

(84) Benannte Vertragsstaaten: **BE DE FR GB IT NL SE**

(56) Entgegenhaltungen:
**EP - A - 0 002 321**
**DE - A - 2 300 371**
**DE - A - 2 415 728**
**DE - A - 2 444 118**
**DE - B - 1 098 656**
**GB - A - 1 440 734**

(73) Patentinhaber: **BASF Aktiengesellschaft, *Carl-Bosch-Strasse 38, D-6700 Ludwigshafen (DE)***

(72) Erfinder: **Jun, Mong-Jon, Dr., Maulbeerstueck 20, D-6720 Speyer (DE)**
Erfinder: **Richter, Peter, Dr., Bensheimer Ring 24, D-6710 Frankenthal (DE)**
Erfinder: **Barzynski, Helmut, Dr., An der Ameisenhalde 49, D-6702 Bad Duerkheim (DE)**

**EP 0 055 807 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft zur Herstellung von Druck- und Reliefformen geeignete Mehrschichten-Elemente mit einer auf einem Polyester-Schichtträger über eine Haftschicht fest verankerten photopolymerisierbaren und/oder -vernetzbaren Schicht auf Basis eines elastomeren Polymer-Bindemittels, die eine verbesserte Stabilität bei der Verarbeitung und Anwendung aufweisen.

Mehrschichten-Elemente für die Herstellung von Reliefdruckplatten mit elastomeren Reliefschichten, wie sie für den Flexodruck eingesetzt werden, sind an sich bekannt und z. B. in den DE-OSen 2 138 582, 2 215 090, 2 456 439, 2 623 801 oder 2 942 183, der CA-PS 614 181 sowie den US-PSen 3 024 180 oder 3 674 486 beschrieben. Diese Mehrschichten-Elemente bestehen im allgemeinen aus einer photopolymerisierbaren und/oder photovernetzbaren Schicht einer Mischung eines Elastomeren mit photopolymerisierbaren Monomeren, die haftfest mit einem dimensionsstabilen Schichtträger, wie z. B. einer Kunststoff-Folie oder einer Metallplatte, verbunden ist. In der DE-OS 2 444 118 wird eine Mehrschichten-Verbundplatte für die Herstellung von Reliefdruckplatten für den Flexodruck beschrieben, bei der die reliefbildende, photoempfindliche Schicht haftfest auf einer dimensionsstabilen Trägerschicht, beispielsweise aus einer Polyesterfolie, verankert ist, die ihrerseits mit einer weichelastischen Unterschicht verbunden ist. Es ist aus den zitierten Druckschriften auch bekannt, daß zur Erzielung einer festen Verankerung der photosensitiven Schicht auf dem dimensionsstabilen Träger zweckmäßigerweise eine dazwischenliegende Haftschicht verwendet wird. Für solche Haftschichten ist beispielsweise der Einsatz von handelsüblichen Ein- oder Zweikomponenten-Reaktionsklebern auf Polyurethan- bzw. Polychloropren-Basis vorgeschlagen worden. Des weiteren wurde bereits empfohlen, als Haftschicht Gemische von polymeren Bindemitteln mit Polymerisationsinitiatoren zu verwenden (vgl. z. B. EP-A2-0 002 321 und US-PS 3 036 913). Ferner ist aus der CH-PS 421 708 bekannt, dünne elastische photopolymerisierbare Elemente aus einer reliefbildenden, photopolymerisierbaren Schicht, einer Sperrschicht und einer härtbaren Klebstoffschicht auf einer elastischen Unterlage, insbesondere einer Polyethylenterephthalatfolie, in der Weise herzustellen, daß auf die mit der härtbaren Klebstoffschicht versehene Polyethylenterephthalatfolie eine Schicht der photopolymerisierbaren Masse aus Monomeren und einem verträglichen polymeren Bindemittel, wie sie auch zur Herstellung der photopolymerisierbaren reliefbildenden Schicht verwandt werden, aufgetragen und teilweise vernetzt wird, und dann eine Schicht der photopolymerisierbaren Masse für die photopolymerisierbare Bildschicht aufgetragen wird. Die härtbare Klebstoffschicht besteht dabei aus einem Mischpolyester und einem Diisocyanat als thermischem Härtemittel.

Es hat sich jedoch in der Praxis gezeigt, daß bei Mehrschichten-Elementen mit einer photosensitiven Schicht auf Basis eines elastomeren Polymeren und einem Träger aus einer Polyesterfolie die Verankerung der photosensitiven Schicht auf der Polyesterfolie auch bei Verwendung der für diese Mehrschichten-Elemente bekannten und beschriebenen Haftvermittler und Haftschichten für die praktische Anwendung nicht zufriedenstellend ist. So kommt es beim Auswaschen von belichteten photopolymeren Mehrschichten-Elementen dieser Art als auch bei der Anwendung der hieraus hergestellten photopolymeren Druck- und Reliefformen, insbesondere durch den Einfluß der hierbei verwendeten organischen Lösungsmittel, immer wieder zu Ablösungen der photopolymeren elastomeren Reliefschicht von der als Schichtträger dienenden Polyesterfolie, wodurch die Druck- oder Reliefformen unbrauchbar werden.

Der vorliegenden Erfindung lag die Aufgabe zugrunde, photosensitive, zur Herstellung von Reliefdruckformen für den Flexodruck geeignete Mehrschichten-Elemente zu schaffen, die auf einem Schichtträger aus Polyester eine photosensitive Schicht auf Basis eines elastomeren Polymeren fest verankert enthalten und die eine verbesserte Verbundfestigkeit zwischen photosensitiver Schicht und Schichtträger bei der Herstellung, der Verarbeitung oder auch Anwendung dieser Mehrschichten-Elemente aufweisen.

Es wurde nun gefunden, daß zur Herstellung von Druck- und Reliefformen geeignete Mehrschichten-Elemente mit

a) einer photosensitiven Schicht einer in aromatischen oder halogenierten aliphatischen Kohlenwasserstoff-Lösungsmitteln löslichen und/oder dispergierbaren Mischung, bestehend im wesentlichen aus

   a1) mindestens einem elastomeren Polymeren als Bindemittel,
   a2) mindestens einem damit verträglichen photopolymerisierbaren, ethylenisch ungesättigten Monomeren,
   a3) einem durch aktinisches Licht aktivierbaren Photopolymerisationsinitiator sowie
   a4) ggf. üblichen Zusatzstoffen,

b) einem Polyesterformkörper als dimensionsstabilem Träger für die photosensitive Schicht (a) und
c) einer Haftschicht aus einem mit Polyisocyanat thermisch gehärteten Klebstoff zwischen der photosensitiven Schicht (a) und dem dimensionsstabilen Träger (b),

die gewünschten Eigenschaften weitgehend aufweisen, wenn die Haftschicht (c) gebildet wird aus einem in den aromatischen oder halogenierten aliphatischen Kohlenwasserstoff-Lösungsmitteln nicht löslichen Gemisch von

c1) 90 bis 40 Gew.-%, vorzugsweise 90 bis 70 Gew.-%, bezogen auf die Summe von (c1) und (c2), eines mit Isocyanat gehärteten und vernetzten hydroxylgruppenhaltigen Polyurethanharzes, Polyesterolharzes, Polyetherolharzes, hydroxylgruppenhaltigen Epoxidharzes oder hydroxylgruppenhaltigen Phenoxiharzes, welches vor der Härtung und Vernetzung mit dem Isocyanat einen Gehalt an freien OH-Gruppen im Bereich von etwa 4 bis 20 Gew.-%, bezogen auf das unvernetzte Harz, und ein Molekulargewicht im Bereich von 500 bis 50 000 aufweist und
c2) 10 bis 60 Gew.-%, vorzugsweise 10 bis 30 Gew.-%, bezogen auf die Summe von (c1) und (c2), eines OH-Gruppen freien Polycarbonats, welches mit dem Harz der Komponente (c1) vor dessen Härtung und Vernetzung verträglich ist.

Die hervorragenden Verbundeigenschaften, die die erfindungsgemäßen Mehrschichten-Elemente aufweisen, sind um so überraschender, als entsprechende Mehrschichten-Elemente mit recht ähnlich aufgebauten Haftschichten diese Eigenschaften nicht aufweisen. So führt selbst der Einsatz eines Klebstoffes aus einem Copolyester, einem Isocyanat und einem Epoxyharz, wie er gemäß Beispiel 14 der DE-OS 2 215 090 als Haftschicht bei der Herstellung von Mehrschichten-Elementen mit einer photopolymerisierbaren Schicht und einem metallischen Schichtträger eingesetzt werden soll, bei Mehrschichten-Elementen mit einer Polyesterfolie als Trägerschicht für die photopolymerisierbare Schicht nur zu einem unbefriedigenden Ergebnis. Die erfindungsgemäßen Mehrschichten-Elemente weisen nicht nur vor sondern auch nach der Belichtung und Entwicklung der photosensitiven Schicht eine gute Haft- und Verbundfestigkeit auf, obwohl die Behandlung der Schichten mit dem Entwickler-Lösungsmittel und das dadurch mögliche Anquellen der Schichtbestandteile bekanntlich eine Verminderung der Verbundfestigkeit bewirken und besondere Probleme bei der Herstellung haftfester schichftförmiger Verbundelemente darstellen.

Als photoempfindliche Schicht (a) einer in aromatischen oder halogenierten aliphatischen Kohlenwasserstoff-Lösungsmitteln löslichen und/oder dispergierbaren Mischung von

a1) mindestens einem elastomeren Polymeren als Bindemittel,
a2) mindestens einem damit verträglichen photopolymerisierbaren ethylenisch ungesättigten Monomeren,
a3) mindestens einem Photopolymerisationsinitiator und
a4) ggf. die Handhabbarkeit und/oder Verarbeitbarkeit verbessernden Zusatzstoffen

kommen beispielsweise Mischungen in Frage, wie sie in den eingangs zitierten Druckschriften, insbesondere den DE-OSen 2 138 582, 2 215 090, 2 456 439 und 2 942 183, beschrieben sind. Elastomere Polymere, die in aromatischen oder halogenierten aliphatischen Kohlenwasserstoff-Lösungsmitteln löslich und/oder quellbar sind und somit als Bindemittel a1) in Betracht kommen, sind insbesondere die entsprechenden Polymeren von konjugierten aliphatischen Diene mit 4 bis 5 Kohlenstoffatomen. Als Beispiele hierfür seien genannt: Naturkautschuk, die Homopolymerisate von Butadien und Isopren, Copolymerisate von Butadien und Isopren untereinander sowie die Copolymerisate von Butadien und/oder Isopren mit anderen copolymerisierbaren Monomeren, wie insbesondere Styrol, Acrylnitril, (Meth)-acrylsäure-alkylestern mit 1 bis 8 Kohlenstoffatomen in der Alkylgruppe und anderen. Beispiele für solche Copolymerisate sind die Nitrilkautschuke (z. B. Butadien-Acrylnitril-Copolymerisate mit einem Acrylnitril-Gehalt von 20 bis 35 Gew.-%); Copolymerisate aus Styrol und Butadien und/oder Isopren mit statistischer Verteilung der Monomeren und einem Gehalt an einpolymerisiertem Styrol von vorzugsweise 10 bis 50 Gew.-%; Blockcopolymerisate aus Styrolmonomeren und Butadien und/oder Isopren. Besonders günstig als Bindemittel (a1) sind Zweiblockcopolymerisate des Typs A-B und Dreiblockcopolymerisate des Typs A-B-A mit einem bzw. zwei thermoplastischen Styrolpolymerisat-Blöcken A und einem elastomeren Butadien- und/oder Isopren-Polymerisatblock B und einem Anteil an einpolymerisiertem Styrol im allgemeinen im Bereich von 10 bis 50 Gew.-% sowie elastomere Dreiblockcopolymerisate des Typs A-B-C mit einem thermoplastischen, nichtelastomeren Styrolpolymerisat-Block A, einem elastomeren Butadien- und/oder Isopren-Polymerisat-Block B und einem von B verschiedenen elastomeren Polymerblock C aus Butadien und/oder Isopren sowie ggf. Styrol, wie sie beispielsweise gemäß der DE-OS 2 942 183 als Bindemittel zum Einsatz gelangen sollen.

Bei den mit dem elastomeren Bindemittel (a1) verträglichen, photopolymerisierbaren, ethylenisch ungesättigten Monomeren (a2) sind die Ester der Acrylsäure und/oder Methacrylsäure mit ein- oder mehrwertigen Alkoholen von besonderer Bedeutung. Hierzu gehören unter anderem Butylacrylat, Butylmethacrylat, 2-Ethylhexylacrylat, Lauryl-(meth)-acrylat, Ethylenglykoldimethacrylat, Butandiol-1,4-diacrylat, Butandiol-1,4-dimethacrylat, Neopentylglykoldimethacrylat, 3-Methylpentandioldiacrylat, 2-Hydroxypropylacrylat, 2-Hydroxyethyl-(meth)-acrylat, Hexandiol-1,6-diacrylat, Hexandiol-1,6-dimethacrylat, 1,1,1-Trimethylolpropantri-(meth)-acrylat, Di-, Tri- und Tetra-ethylenglykoldiacrylat, Tripropylenglykoldiacrylat, Pentaerythrit-tetraacrylat. Geeignet sind auch Vinylester aliphatischer Monocarbonsäuren, wie Vinyloleat, und Vinylether von Alkoholen, wie Octadecylvinylether oder Butandiol-1,4-divinylether.

Das Verhältnis von elastomerem Bindemittel (a1) zu den photopolymerisierbaren, ethylenisch ungesättigten Monomeren (a2) in der photosensitiven Schicht (a) liegt im allgemeinen im Bereich von 60 bis 95 Gew.-% an elastomerem Bindemittel (a1) zu 5 bis 40 Gew.-% an photopolymerisierbaren, ethylenisch ungesättigten Monomeren (a2).

Die photosensitive Schicht (a) enthält darüber hinaus eine wirksame Menge, im allgemeinen 0,01 bis 10 Gew.-% und insbesondere 0,05 bis 5 Gew.-%, bezogen auf die Komponenten der photosensitiven Schicht (a), mindestens eines Photopolymerisationsinitiators, wie z. B. Benzoin oder Benzoinderivate, wie dessen Methyl-, Isopropyl-, n-Butyl- oder Isobutylether; symmetrisch oder unsymmetrisch substituierte Benzilketale, wie Benzildimethylketal, Benzilmethylethylketal; oder Acylphosphinoxide des Typs, wie sie z. B. in der DE-OS 2 909 992 beschrieben sind. Die photosensitive Schicht (a) kann ferner noch weitere Zusatzstoffe enthalten, wie sie zur Verbesserung der Handhabbarkeit und Verarbeitbarkeit von Mehrschichten-Elementen der in Rede stehenden Art üblich und bekannt sind. Hierzu gehören insbesondere thermische Polymerisationsinhibitoren, wie beispielsweise p-Methoxyphenol, Hydrochinon oder Salze des N-Nitrosocyclohexylhydroxylamins; Farbstoffe, photochrome Substanzen, Antioxidantien und/oder Weichmacher. Die Zusatzstoffe sind in der photosensitiven Schicht (a) in den für diese Substanzen üblichen und bekannten Mengen enthalten, wobei der Gesamtanteil der Zusatzstoffe an der photosensitiven Schicht (a) im allgemeinen 30 Gew.-% nicht übersteigen soll und insbesondere im Bereich von 5 bis 20 Gew.-%, jeweils bezogen auf die Summe der Komponente der photosensitiven Schicht (a), liegt.

Als dimensionsstabiler Träger (b) für die photosensitive Schicht (a) dient bei den erfindungsgemäßen Mehrschichten-Elementen ein Polyesterformkörper, insbesondere eine Polyester-Folie, z. B. aus Polyethylenterephthalat oder Polybutylenterephthalat. Die als dimensionsstabiler Träger (b) eingesetzte Polyesterfolie hat dabei — je nach Aufbau des Mehrschichten-Elementes — im allgemeinen eine Schichtdicke im Bereich von 50 bis 300 µm. Die Oberfläche der Polyesterfolie kann dabei zur Erzielung einer besseren Haftfestigkeit ggf. mechanisch, chemisch oder beispielsweise durch Substrieren mit einer dünnen Schicht, vorzugsweise einer Stärke von 2 bis 25 µm, eines üblichen Ein- oder Mehrkomponenten-Klebers, beispielsweise auf Polyurethan- oder Polychloropren-Basis vorbehandelt sein.

Erfindungsgemäß besitzen die Mehrschichten-Elemente zwischen der photosensitiven Schicht (a) und der dimensionsstabilen Trägerschicht (b) zur festen Verankerung dieser beiden Schichten eine dünne Haftschicht (c), die gebildet wird aus einem in aromatischen oder halogenierten aliphatischen Kohlenwasserstoff-Lösungsmitteln nicht löslichen Gemisch von

(c1) 90 bis 40 Gew.-%, insbesondere 90 bis 70 Gew.-%, bezogen auf die Haftschicht (c), eines mit Isocyanat gehärteten und vernetzten hydroxylgruppenhaltigen Polyurethanharzes, Polyesterolharzes, Polyetherolharzes, hydroxylgruppenhaltigen Epoxidharzes oder hydroxylgruppenhaltigen Phenoxiharzes, welches vor der Härtung und Vernetzung mit dem Isocyanat einen Gehalt an freien OH-Gruppen im Bereich von etwa 4 bis 20 Gew.-%, vorzugsweise im Bereich von 5 bis 10 Gew.-%, bezogen auf das ungehärtete und unvernetzte Harz, und ein Molekulargewicht im Bereich von 500 bis 50 000 aufweist, und

(c2) 10 bis 60 Gew.-%, vorzugsweise 10 bis 30 Gew.-%, bezogen auf die Haftschicht (c), eines OH-Gruppen freien Polycarbonats, welches mit dem Harz der Komponente (c1) vor dessen Härtung und Vernetzung verträglich ist.

Zur Herstellung dieser Haftschicht geht man dementsprechend von einer innigen Mischung eines freie OH-Gruppen enthaltenden Harzes, einer Isocyanat-Komponente sowie eines entsprechenden Polycarbonats aus.

Die mit Isocyanaten härtbaren hydroxylgruppenhaltigen Polyurethanharze, Polyesterolharze, Polyetherolharze, hydroxylgruppenhaltigen Epoxidharze und hydroxylgruppenhaltigen Phenoxiharze für die Herstellung der Komponente (c1) der Haftschicht (c) haben vorzugsweise ein Molekulargewicht im Bereich von 900 bis 30 000. Bevorzugt sind hierbei die entsprechenden Epoxidharze und speziell Phenoxiharze. Besonders günstig sind in organischen Lösungsmitteln lösliche, lineare, aromatische Gruppen in der Kette enthaltende Epoxidharze mit Molekulargewichten im Bereich von 900 bis 11 000, insbesondere von 2500 bis 10 000, und Epoxidäquivalenten von 0,15 bis 0,01, vorzugsweise von 0,1 bis 0,02, bezogen auf 100 g Harz, sowie die ähnlich aufgebauten sogenannten Phenoxiharze mit Molgewichten von 10 000 und 50 000, vorzugsweise zwischen 20 000 und 30 000, die keine oder nur unwesentliche Mengen an Epoxidgruppen enthalten. Diese bevorzugten Epoxidharze bzw. Phenoxiharze enthalten insbesondere 4 bis 8 Gew.-%, vorzugsweise 5 bis 7 Gew.-%, bezogen auf das Harz, an OH-Gruppen. Als geeignete Epoxidharze seien insbesondere die aus Bisphenol-A und Epichlorhydrin hergestellten hydroxylgruppenhaltigen Produkte genannt, wie z. B. handelsübliche Epoxidharze, hergestellt aus Bisphenol-A und Epichlorhydrin, die ein Expoxidäquivalent von ca. 0,055 (bezogen auf 100 g Harz), einen OH-Gehalt von 6,1 Gew.-% und ein Molekulargewicht von 2900 aufweisen; aus den gleichen Komponenten hergestellte Epoxidharze mit einem Epoxidäquivalent von ca. 0,03 (bezogen auf 100 g

Harz), einem OH-Gehalt von 6,8 Gew.-% und einem Molekulargewicht von 3700 bis 3800 oder ebensolche handelsübliche Produkte mit Epoxidäquivalenten von 0,02 bis 0,04 (bezogen auf 100 g Harz), OH-Gehalten von 5,2 bis 5,5 Gew.-% und Molekulargewichten von ca. 5500 bis 9000. Als Vertreter für die bevorzugten Phenoxiharze seien beispielhaft die linearen polymeren Diglycidether des Bisphenol-A mit wiederkehrenden Struktureinheiten der Formel

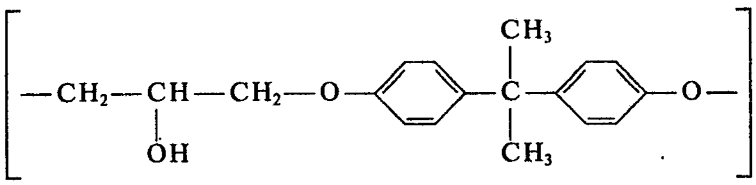

erwähnt.

Die härtbaren Harze mit den freien OH-Gruppen der Komponente (c1) können zur Herstellung der Haftschicht (c) allein oder in Mischung miteinander eingesetzt werden.

Als Isocyanat-Komponente, die zur Härtung und Vernetzung der oben beschriebenen härtbaren Harze der Komponente (c1) der Haftschicht (c) verwendet wird, kommen die aus der Polyurethanchemie bekannten und üblichen Di- und Polyisocyanate in Betracht, vorzugsweise solche mit zwei oder mehr aromatisch gebundenen Isocyanatgruppen. Als Beispiele hierfür seien genannt: 1,6-Hexamethylendiisocyanat, Dicyclohexylmethan-4,4'-diisocyanat, Isophorondiisocyanat, 2,4- und 2,6-Toluylendiisocyanat, m-Phenylendiisocyanat, Xylylendiisocyanat, Diphenylmethan-4,4'-diisocyanat, Naphthylen-1,5-diisocyanat, 3,3'-Dimethyldiphenyl-4,4'-diisocyanat, Triphenylmethan-4,4',4"-triisocyanat, 1,4-Cyclohexylendiisocyanat. Die Isocyanate werden für die Härtung der hydroxylgruppenhaltigen Harze in solchen Mengen eingesetzt, daß das Verhältnis der Äquivalente der NCO-Gruppen zu den freien OH-Gruppen der härtbaren Harze von 0,8 bis 1,6, insbesondere von 1,0 bis 1,2 beträgt.

Als Polycarbonate, die in der Haftschicht (c) der erfindungsgemäßen Mehrschichten-Elemente enthalten sein sollen, kommen die bekannten und handelsüblichen Polycarbonate in Betracht, die keine freien OH-Gruppen mehr haben und die mit dem härtbaren Harz der Komponente (c1) vor dessen Aushärtung verträglich sind. Das Molekulargewicht der Polycarbonate liegt im allgemeinen im Bereich von 25 000 bis 75 000, vorzugsweise von 25 000 bis 50 000. Vorzugsweise kommen Polycarbonate, insbesondere lösliche Polycarbonate in Betracht, wie sie z. B. durch Umsetzung von 4,4'-Dihydroxydiphenyl-alkanen, wie z. B. 4,4'-Dihydroxydiphenylpropan-2,2 oder 4,4'-Dihydroxydiphenyl-methan, mit Phosgen oder Kohlensäureestern erhalten werden.

Das Vermischen der härtbaren Harze, der Isocyanate und der Polycarbonate zur Herstellung der erfindungsgemäßen Haftschicht (c) erfolgt zweckmäßigerweise durch gemeinsames Lösen der Komponenten in einem geeigneten Lösungsmittel, beispielsweise Tetrahydrofuran oder Mischungen von Tetrahydrofuran mit aromatischen Lösungsmitteln, wie z. B. Xylol. Im allgemeinen enthalten diese Lösungen so viel Lösungsmittel, daß Verarbeitungsviskositäten von 200 mPas bei Raumtemperatur resultieren. Die Lösung der Komponenten für die Haftschicht (c) wird dann in an sich bekannter Weise, z. B. durch Streichen, Aufwalzen, Spritzen oder Gießen, auf die als Träger (b) dienende Polyester-Folie aufgebracht. Nach Ablüften des Lösungsmittels wird die Schicht (c) bei höheren Temperaturen ggf. unter verringertem Druck getrocknet und eingebrannt. Die Stärke der aufgetragenen Schicht wird dabei zweckmäßigerweise so gewählt, daß die gehärtete Haftschicht (c) nach dem Einbrennen eine Schichtdicke von 2 bis 25 µm, insbesondere von 5 bis 20 µm, aufweist. Das Trocknen und Einbrennen, bei dem die Haftschicht (c) gehärtet wird, erfolgt üblicherweise bei Temperaturen im Bereich von 80 bis 200°C, insbesondere 90 bis 150°C, im allgemeinen innerhalb eines Zeitraumes von 0,5 bis 20 Minuten, insbesondere innerhalb von 0,5 bis 5 Minuten. Die optimale Erhitzungsdauer und -temperatur für eine Haftschicht hängt dabei von den verwendeten Komponenten ab und ist auf diese abzustimmen. Die Härtung und Vernetzung der Haftschicht (c) soll dabei vorzugsweise so weit durchgeführt werden, daß nach der Härtung und Vernetzung die Haftschicht (c) in aromatischen und/oder halogenierten aliphatischen Kohlenwasserstoff-Lösungsmitteln unlöslich aber noch anquellbar ist. Die Komponenten der Haftschicht (c) werden vorteilhafterweise so gewählt, daß die Haftschicht (c) nicht nur nach dem Härten, d. h. dem Trocknen und Einbrennen der Schicht, transparent ist, sondern auch nach einer Behandlung mit Lösungsmitteln, beispielsweise dem Auswaschen der belichteten Mehrschichten-Elemente, transparent bleibt. Dies bringt Vorteile bei der Handhabung und Anwendung der Mehrschicht-Elemente.

Den Mischungen der Komponenten für die Haftschicht (c) können bei der Herstellung natürlich auch Pigmente, Pigmentierhilfsmittel und sonstige, die Verarbeitung günstig beeinflussende Stoffe zugesetzt werden, wie z. B. übliche Katalysatoren für die Beschleunigung der Polyisocyanathärtung. Häufig ist es von Vorteil, wenn die Haftschicht (c) als Lichthofschutz Farbstoffe enthält, die Licht im aktinischen Wellenlängenbereich absorbieren. Dies ist insbesondere dann günstig, wenn die photosensitive Schicht (a) der Mehrschicht-Elemente nur verhältnismäßig dünn ist.

Die Farbstoffe können dabei in solchen Mengen in der Schicht (c) enthalten sein, daß hierdurch bis zu 30% des einfallenden Lichts absorbiert werden. Die in der Haftschicht (c) enthaltenen Farbstoffe

sollen dabei nicht in die photosensitive Schicht (a) diffundieren können und sollen, beispielsweise durch Restlösungsmittel in der photosensitiven Schicht (a) oder durch die Druckfarbenlösungsmittel, nicht extrahierbar sein. Geeignete Farbstoffe sind beispielsweise solche mit reaktiven Gruppen, die bei der Isocyanat-Härtung der Haftschicht (c) in dieser Schicht fixiert werden, z. B. Michlers Keton-Derivate mit 2 oder mehr Hydroxyl-Gruppen. Weiterhin sind nicht wandernde Farbstoffe geeignet, wie z. B. Zapponechtschwarz (C.I. 12195, solvent black 34) oder Auramin FA (C.I. 41000, basic yellow 2).

Die Herstellung der erfindungsgemäßen Mehrschicht-Elemente mit einer auf einer Polyester-Folie als Träger (b) aufgebrachten photosensitiven Schicht (a) die über die spezielle Haftschicht (c) fest haftend miteinander verbunden sind, kann auf an und für sich übliche und bekannte Weise erfolgen. Üblicherweise wird zunächst die Haftschicht (c) auf die als Trägerschicht (b) dienende Polyesterfolie in der oben beschriebenen Art und Weise aufgetragen und auf diesen Verbund aus gehärteter Haftschicht (c) und Trägerschicht (b) wird dann die photosensitive Schicht (a) beispielsweise durch Gießen einer Lösung der Komponenten der Schicht (a) und Abdampfen des Lösungsmittels, aufgebracht. Gleichermaßen kann natürlich die photosensitive Schicht (a) auch zunächst separat, beispielsweise durch Gießen aus einer Lösung oder durch Extrudieren, hergestellt werden und diese so vorgefertigte Schicht (a) anschließend auf den Verbund aus gehärteter Haftschicht (c) und Trägerschicht (b) auflaminiert oder aufgepreßt werden. Bei der letztgenannten Methode kann es zweckmäßig und vorteilhaft sein, vor dem Auflaminieren der vorgefertigten photosensitiven Schicht (a) die gehärtete Haftschicht (c) zuvor mit einer dünnen, etwa 5 bis 50 µm starken Oberschicht zu versehen, die die gleiche oder eine ähnliche Zusammensetzung wie die photosensitive Schicht (a) besitzt. Diese dünne Oberschicht wird dabei am besten durch Gießen aus einer Lösung der Komponenten erzeugt.

Die erfindungsgemäßen Mehrschichten-Elemente eignen sich insbesondere zur Herstellung von Druck- und Reliefformen, was in an sich bekannter Weise durch bildmäßiges Belichten der photosensitiven Schicht (a) mittels aktinischem Licht, vorzugsweise einer Wellenlänge im Bereich von 230 bis 450 nm, insbesondere von 300 bis 420 nm, und anschließendes Auswaschen der unbelichteten Bereiche mit einem geeigneten Entwickler-Lösungsmittel, wie beispielsweise aromatischen Kohlenwasserstoffen oder halogenierten aliphatischen Kohlenwasserstoff-Lösungsmitteln erfolgen kann. Die photosensitive Schicht (a) hat im allgemeinen eine Schichtstärke im Bereich von 200 bis 7000 µm. Da sich die erfindungsgemäßen Mehrschichten-Elemente insbesondere zur Herstellung von weichelastischen Druckplatten eignen, wie sie z. B. beim Flexodruck zur Anwendung kommen, hat die Reliefschicht (a) nach der Belichtung und Photovernetzung insbesondere eine Shore A-Härte (DIN 53 505) von 15 bis 70. Die erfindungsgemäßen Mehrschichten-Elemente eignen sich auch zur Herstellung von Reliefdruckplatten, wie sie z. B. in der DE-OS 2 444 118 beschrieben sind, bei denen die Trägerschicht (b) für die reliefbildende, photosensitive Schicht (a) ihrerseits nochmals mit einer elastomeren Unterschicht verbunden ist und somit gleichzeitig als Stabilisierungsschicht für den Verbund dient. Es werden Druck- und Reliefformen erhalten, deren Reliefs auch bei wiederholter und längerer Behandlung mit Lösungsmitteln eine ausgezeichnete Haftung auf dem Polyester-Träger zeigen.

Die Erfindung wird durch die nachfolgenden Beispiele weiter erläutert. Die in den Beispielen genannten Teile und Prozente beziehen sich, soweit nicht anders angegeben, auf das Gewicht. Teile verhalten sich zu Volumenteilen wie kg zu Liter.

## Beispiel 1

Eine lichtempfindliche Schicht wird aus 85 Teilen eines A-B-C-Blockcopolymerisats gemäß DE-OS 2 942 183, 5 Teilen Hexandiol-1,6-diacrylat, 5 Teilen Hexandioldimethacrylat, 1,3 Teilen Benzildimethylketal, 0,4 Teilen 2,6-Di-tert.-butyl-p-Kresol und 0,006 Teilen eines schwarzen Farbstoffs (C.I. 26150, Solvent Black 3) aus toluolischer Lösung auf eine mit einer 5 µm dicken Schicht aus Polyvinylbutyrol beschichteten Polyesterfolie aufgegossen und getrocknet, so daß eine 1,7 mm dicke Schicht zurückbleibt.

Auf eine weitere Polyesterfolie wird eine 10%ige Haftlacklösung in Tetrahydrofuran aufgebracht und 15 min bei 120°C in einem Frischlufttrockenschrank getrocknet. Die Schichtdicke beträgt 5 µm. Die Haftlacklösung wird aus 75 Teilen eines Phenoxiharzes (PKHH, Hersteller Union Carbide Corp.), 25 Teilen eines handelsüblichen Polycarbonats (Makrolon 2800, Hersteller Bayer AG) und einer stöchiometrischen Menge Polyisocyanat (Desmodur L 75, Hersteller Bayer AG) durch Lösen in Tetrahydrofuran hergestellt. Anschließend wird die freie Schichtseite der lichtempfindlichen Schicht auf die Oberfläche der gehärteten Haftlackschicht in einem Kaschierwerk aufgewalzt.

Die lichtempfindliche Schicht wird von der Seite der Haftlackschicht 2,5 min und von der Seite der Deckfolie her 20 min in einem handelsüblichen Flachbelichter mit 60 Watt UV-Röhren belichtet. Die Probe wird in 2 cm breite Streifen zerschnitten und die Trägerfolie wird mit Hilfe einer Doppelklebefolie auf einen Blechstreifen aufgeklebt. Die Haftungsmessung wird an einem Instron-Prüfgerät unter senkrechtem Abzug der belichteten Photoschicht von der Trägerfolie vorgenommen. Die gemessenen Haftungswerte sind größer 2,5 kg pro 2 cm Probestreifen (Abzugsgeschwindigkeit 30 mm/min) und durchweg größer als die Reißfestigkeit der lichtvernetzten Photoschicht selbst.

Eine weitere Probe des Mehrschichten-Elements wird wie oben beidseitig belichtet, 5 min in einem

handelsüblichen Auswaschgerät (Sprühwascher) in einem Lösungsmittelgemisch aus Tetrachlorethylen/n-Butanol (8 : 2 Vol.-Teile) ausgewaschen und 1 Stunde bei 80°C in einem Trockenschrank getrocknet. Die anschließend in gleicher Weise vorgenommene Haftungsprüfung zeigt keine Reduzierung der Haftwerte.

Eine weitere Probe wird wie oben beidseitig belichtet und anschließend in ein Lösungsmittelgemisch aus 7 Vol.-Teilen Ethanol und 3 Vol.-Teilen Ethylacetat getaucht. Nach 6 h Verweilzeit wird die Probe der gleichen Haftungsprüfung unterzogen. Die gemessenen Haftwerte liegen für die Grenzfläche Haftlackschicht zu Photoschicht bei ca. 1,0 kp/2 cm und für die Grenzfläche Haftlackschicht zu Polyesterfolienoberfläche bei 0,5 bis 0,6 kp/2 cm.

## Beispiel 2

Für eine Mehrschichtendruckplatte wird eine lichtempfindliche Schicht von 0,7 mm Dicke, hergestellt nach Beispiel 5 der DE-OS 2 942 183, auf eine weichelastische Unterschicht, hergestellt nach Beispiel 3 der DE-OS 2 942 183, aufgebracht, wobei zuvor die inmitten des Mehrschichten-Elements liegende Polyesterfolie von 75 µm Dicke der weichelastischen Unterschicht mit einem Haftlack aus Phenoxiharz (PKHH der Firma UCC), Polycarbonat (Makrolon 2800 der Fa. Bayer) und einem Polyisocyanat (Desmodur L der Fa. Bayer) nach Beispiel 1 in einer Dicke von 5 µm beschichtet wurde. Die Härtung der Haftlackschicht erfolgte bei 120°C 10 min. Der Haftlack enthält als Lichthofschutz ein Gemisch aus 4,4'-Bis-(N-$\beta$-hydroxiethyl-N-methyl-amino)-benzophenon und Auramin FA (BASF, Basic Yellow 2) im Verhältnis 4 : 1; die Extinktion der Haftlackschicht von 5 µm Dicke bei 360 nm wird auf 0,30 eingestellt.

Bei einer Belichtungstestreihe zeigte die Platte einen großen Belichtungsspielraum, d. h. freistehende Reliefelemente sehr geringen Durchmessers, wie Linien von 150 µm Dicke, sind breit versockelt auf der Polyesterfolie und haftfest mit ihr verbunden. Gleichzeitig zeigen die Näpfchen von Rasterfeldern noch sehr hohe Tiefenwerte, so daß randscharfe, saubere Druckergebnisse erhalten werden. Die nach Beispiel 1 durchgeführte Haftungsprüfung ergibt gleiche Werte.

Wird auf eine derartige Platte eine Negativvorlage mit Gitterlinien, Linien, feinen Strichzeichnungen aufbelichtet (Belichtungszeit 12 min) und wird anschließend in einem handelsüblichen Sprühwascher mit einem Lösungsmittelgemisch von 8 : 2 Vol.-Teilen Tetrachloräthylen/n-Butanol 1 mm länger als die erforderliche Auswaschzeit von 4 min entwickelt, so zeigen sich an den aufbelichteten Reliefteilen keinerlei Ablöseerscheinungen in der Form, daß sich Linien vom Haftgrund ablösen oder sich verziehen. Die Bildwiedergabe bleibt vorlagengetreu erhalten.

## Vergleichsbeispiel

Eine Mehrschichtenplatte wird wie in Beispiel 2 beschrieben gefertigt mit dem Unterschied, daß die Haftlackschicht aus 100 Teilen Phenoxiharz (PKHH von UCC), 114,6 Teilen Polyisocyanat (Desmodur L der Fa. Bayer) sowie des gleichen Gemisches aus 4,4'-Bis-(N-$\beta$-hydroxiethyl-N-methyl-amino)-benzophenon und Auramin FA als Lichthofschutz mit gleicher Lichtabsorption von $E = 0,3$ bei 360 nm bei 5 µm Dicke besteht, also kein Polycarbonat enthält.

Die Haftlackschicht wird aus einer Lösung in Tetrahydrofuran aufgetragen, daß eine Schichtdicke von ca. 5 bis 7 µm resultiert, und bei 120°C 10 min getrocknet. Die lichtempfindliche Schicht wird in gleicher Weise wie in Beispiel 2 mit einem feine Linie, Gitter und Strichzeichnungen enthaltenden Negativ 12 min belichtet und anschließend 5 min im gleichen Lösungsmittel wie in Beispiel 2 entwikkelt. Die Linien und Gitter zeigen insbesondere an den auslaufenden Enden deutliche Ablöseerscheinungen, die auf mangelnde Haftung zurückzuführen sind.

## Beispiel 3

Eine Mehrschichtenplatte gemäß DE-OS 2 942 183 wurde hergestellt aus

a) einer lichtempfindlichen Reliefschicht bestehend aus 85 Teilen eines ABC-Blockcopolymeren (Block A: Polystyrol, Block B: Polyisopren, Block C: Styrol/Butadien-Copolymer; Verhältnis A : B : C = 1 : 7,6 : 1,4), 5 Teilen Hexandiol-1,6-diacrylat, 5 Teilen Butandiol-1,4-dimethacrylat, 2 Teilen Trimethylolpropantriacrylat, 1,0 Teilen Benzildimethylketal, 0,5 Teilen 2,6-Di-tert.-butyl-p-kresol, 0,006 Teilen eines schwarzen Farbstoffs (C.I. 26150, Solvent Black 3) und 5 Teilen eines Paraffinöls (mediz. Weißöl);
b) einer Unterschicht aus 60 Teilen des gleichen Blockcopolymeren, 30 Teilen Paraffinöl, 10 Teilen Hexandiol-1,6-dimethacrylat, 0,6 Teilen Benzildimethylketal.

Eine 75 µm dicke Polyesterfolie wird beidseitig mit einer Haftlackschicht aus 75 Teilen Phenoxiharz, 25 Teilen Polycarbonat und stöchiometrischen Mengen Toluylendiisocyanat in 10 µm Dicke beschichtet. Die Haftlackschicht zur Reliefschicht ist zusätzlich mit einem nicht extrahierbaren, wenig diffundierenden Farbstoff (Zapponechtschwarz, C.I. 12195, Solvent black 34) und Michlers-Keton als Lichthofschutz eingefärbt. Bevor die Reliefschicht aufkaschiert wird, wird auf die gehärtete Haftlackschicht eine weitere Schicht in 20 µm Dicke aus 90 Teilen des ABC-Blockcopolymeren der Reliefschicht, 10 Teilen Hexandiol-1,6-dimethacrylat, 1,5 Teilen Benzildimethylketal aufgetragen und 130 sec mit einem Flachbelichter vorbelichtet. Anschließend wird auf die klebrige Oberfläche die bereits vorbereitete Reliefschicht aufgewalzt. Die Haftwerte der unbelichteten Schicht liegen bereits so hoch, daß sie ohne Zerreißen nicht abziehbar ist. Nach vollflächiger Belichtung (20 min) sturwaschen (4 min) und Trocknen (80° C, 1 Stunde) liegen die Haftwerte >3 kp/2 cm, der Haftlack ist nicht von der Polyesterfolie ablösbar.

Nach 6stündigem Tauchen in ethanolhaltige Druckfarbe ist die Haftung nur unwesentlich abgesunken. Ablöseerscheinungen treten nicht auf.

Beispiel 4

Ein Mehrschichten-Element mit einer photopolymerisierbaren Schicht auf Basis eines Styrol/Butadien-Zweiblock-Copolymeren mit 30% Styrolanteil wird hergestellt in folgender Reihenfolge:

Eine 125 µm dicke Polyethylenterephthalatfolie wurde mit 5 µm eines Polyurethan-Zweikomponenten-Klebers beschichtet. Nach 2minütigem Einbrennen bei 120° C wird eine 20 µm dicke Schicht aus 75 Teilen Polyamid (Ultramid 1C, BASF), 25 Teilen Bis-(N-methylol-acrylamid)-glycolether, 1,8 Teilen Benzildimethylketal aus Methanol/$H_2O$ aufgetragen und getrocknet und 60 sec vorbelichtet. Anschließend wird eine 10 µm dicke Haftschicht aus 75 Teilen Phenoxiharz (PKHH, der Fa. UCC), 25 Teilen Polycarbonat und 86 Teilen eines Polyisocyanats (Desmodur L, Fa. Bayer) aufgebracht und 30 min bei 140° C gehärtet. Eine photoempfindliche Schicht die analog Beispiel 3 aufgebaut ist, aber anstelle des Dreiblockcopolymerisats das oben erwähnte Zweiblockcopolymerisat enthält, wird aufgewalzt und belichtet.

Die Haftwerte des Mehrschichten-Elements liegen höher als die Reißfestigkeit der Polyphotomerschicht, d. h. >3 kp/2 cm Probestreifen. Nach 6stündigem Tauchen einer 20 min belichteten Probe in Ethanol/Ethylacetat (7 : 3 Gew.-Teile) ergeben sich Haftwerte von 0,7 bis 0,8 kp/2 cm Probestreifen.

Beispiel 5

Auf eine Polyesterfolie wird eine Haftlackschicht aufgebracht aus 75 Teilen Phenoxiharz, stöchiometrischen Mengen eines Polyisocyanats, 25 Teilen Polycarbonat, 7 Teilen Hexandiol-1,6-diacrylat, 4 Teilen Hexandiol-1,6-dimethacrylat, 1,2 Teilen Benzildimethylketal und 0,24 Teilen eines gelben Farbstoffs (C.I. 41000, basic yellow 2). Nach Einbrennen einer 8 µm dicken Schicht (2 min bei 100° C) wird eine Zwischenschicht gemäß Beispiel 3 aufgebracht und anschließend eine Reliefschicht gemäß Beispiel 3 aufkaschiert. Die gemessenen Haftwerte liegen bei belichteten und ausgewaschenen Proben bei 2,5 kp/2 cm, nach 6stündigem Tauchen der belichteten Proben in einem Ethanol/Ethylacetat-Gemisch (7 : 3) bei 0,3 kp/2 cm.

Beispiel 6

Auf eine Haftschicht aus Beispiel 2 wird eine photoempfindliche Reliefdruckschicht aus 90 Teilen eines Acrylnitril-Butadien-Kautschuks mit 28% Acrylnitrilgehalt und einer Mooney Viskosität von 40,4 Teilen Hexandiol-1,6-diacrylat, 4 Teilen Hexandiol-1,6-dimethacrylat, 3 Teilen Trimethylolpropantriacrylat, 1,3 Teilen Benzildimethylketal, 0,005 Teilen Sudantiefschwarz (Solvent Black 3, C.I. 26150) aufgebracht. Nach 30minütigem Belichten einer 1,7 mm dicken Reliefschicht, 5minütigem Auswaschen in 1,1,1-Trichlorethan werden Haftwerte von 2,2 kp/2 cm gemessen.

**Patentansprüche**

1. Zur Herstellung von Druck- und Reliefformen geeignete Mehrschichten-Elemente mit

a) einer photosensitiven Schicht einer in aromatischen oder halogenierten aliphatischen Kohlenwasserstoff-Lösungsmitteln löslichen und/oder dispergierbaren Mischung, bestehend im wesentlichen aus

a1) mindestens einem elastomeren Polymeren als Bindemittel,

a2) mindestens einem damit verträglichen photopolymerisierbaren, ethylenisch ungesättigten Monomeren,
a3) einem durch aktinisches Licht aktivierbaren Photopolymerisationsinitiator sowie
a4) ggf. üblichen Zusatzstoffen,

b) einem Polyesterformkörper als dimensionsstabilem Träger für die photosensitive Schicht (a) und
c) einer dünnen Haftschicht zwischen der Schicht (a) und dem Träger (b) aus einem mit Polyisocyanat thermisch gehärteten Klebstoff,

dadurch gekennzeichnet, daß die Haftschicht (c) gebildet wird aus einem in den aromatischen oder halogenierten aliphatischen Kohlenwasserstoff-Lösungsmitteln nicht löslichen Gemisch von

c1) 90 bis 40 Gew.-%, bezogen auf die Summe von (c1) und (c2), eines mit Isocyanat gehärteten und vernetzten hydroxylgruppenhaltigen Polyurethanharzes, Polyesterolharzes, Polyetherolharzes, hydroxylgruppenhaltigen Epoxidharzes oder hydroxylgruppenhaltigen Phenoxiharzes, welches vor der Härtung und Vernetzung mit dem Isocyanat einen Gehalt an freien OH-Gruppen im Bereich von etwa 4 bis 20 Gew.-%, bezogen auf das Harz, und ein Molekulargewicht im Bereich von 500 bis 50 000 aufweist, und
c2) 10 bis 60 Gew.-%, bezogen auf die Summe von (c1) und (c2), eines OH-Gruppen-freien Polycarbonats, welches mit dem Harz der Komponente (c1) vor dessen Härtung und Vernetzung verträglich ist.

2. Mehrschichten-Element gemäß Anspruch 1, dadurch gekennzeichnet, daß die Haftschicht (c) zusätzlich Farbstoffe enthält.

3. Mehrschichten-Elemente gemäß Ansprüchen 1 oder 2, dadurch gekennzeichnet, daß sie als Träger (b) eine gegebenenfalls mechanisch, chemisch und/oder durch Versehen mit einer Haftgrundierung vorbehandelte Polyesterfolie enthalten.

**Claims**

1. A multi-layer element, suitable for the production of printing plates and relief plates, which comprises

a) a photosensitive layer of a mixture which is soluble and/or dispersible in aromatic hydrocarbon solvents or aliphatic halohydrocarbon solvents and consists essentially of

a1) at least one elastomeric polymer as the binder,
a2) at least one photopolymeriszable, ethylenically unsaturated monomer compatible with the binder, and
a3) a photopolymerization initiator which can be activated by actinic light, with or without
a4) conventional additives,

b) a polyester shaped article as the dimensionally stable base for the photosensitive layer (a), and
c) a thin adhesive layer, between the layer (a) and base (b), consisting of a thermally polyisocyanate-hardened adhesive,

wherein the adhesive layer (c) is obtained from a mixture which is insoluble in the aromatic hydrocarbon solvents or aliphatic halohydrocarbon solvents, and contains

c1) from 90 to 40% by weight, based on the sum of (c1) and (c2), of a hydroxyl-containing polyurethane resin, a polyester-ol resin, a polyether-ol resin, a hydroxyl-containing epoxy resin or a hydroxyl-containing phenoxy resin, each of which resins has been hardened and crosslinked with isocyanate, contains from about 4 to 20% by weight, based on the resin, of free OH groups and has a molecular weight of from 500 to 50,000 before hardening and crosslinking with the isocyanate, and
a2) from 10 to 60% by weight, based on the sum of (c1) and (c2), of an OH-free polycarbonate which is compatible with the resin (c1) before the latter is hardened and crosslinked.

2. A multi-layer element as claimed in claim 1, wherein the adhesive layer (c) additionally contains a dye.

3. A multi-layer element as claimed in claim 1 or 2, containing, as the base (b), a polyester film which may have been pre-treated mechanically, chemically and/or by providing it with an adhesive coating.

**Revendications**

1. Eléments multi-couches appropriés pour la fabrication de formes d'impression et en relief, comportant

a) une couche photosensible d'un mélange, soluble et/ou dispersable dans un solvant d'hydrocarbure aromatique ou aliphatique halogéné, constitué essentiellement de

a1) au moins un polymère élastomère comme liant,
a2) au moins un monomère éthyléniquement insaturé, photopolymérisable, et compatible avec le précédent,
a3) un inituateur de photopolymérisation activable par la lumière actinique, ainsi que
a4) eventuellement des additifs usuels,

b) un corps de forme en polyester, comme support de dimension stable pour la couche photosensible (a) et
c) une couche d'adhérence mince, entre la couche (a) et le support (b), en matière adhésive durcie thermiquement avec du polyisocyanate

caractérisé par le fait que la couche adhérente (c) est formée d'un mélange, non soluble dans le solvant d'hydrocarbure aromatique ou aliphatique halogéné, de

c1) 90 à 40% en poids, par rapport à la somme de (c1) et (c2), d'une résine de polyuréthane, à groupeshydroxyle, polyestérol, polyéthérol, époxy à groupes hydroxyle ou phénoxy à groupes hydroxyle, réticulée et durcie avec un isocyanate, et qui, avant le durcissement et la réticulation avec l'isocyanate, possède une teneur en groupes OH libres dans les limites d'environ 4 à 20% en poids, rapportée à la résine, et un poids moléculaire dans les limites de 500 à 50 000, et
c2) 10 à 60% en poids, par rapport à la somme de (c1) et (c2), d'un polycarbonate, exempt de groupes OH, qui est compatible avec la résine du composant (c1), avant son durcissement et sa réticulation.

2. Eléments multi-couches selon la revendication 1, caractérisés par le fait que la couche adhérente (c) contient en outre des colorants.

3. Eléments multi-couches selon les revendications 1 ou 2, caractérisés par le fait qu'ils contiennent, comme support (b), une feuille de polyester pré-traitée éventuellement, par voie mécanique, chimique et/ou en étant munie d'une base adhérente.